# EUROPEAN PATENT SPECIFICATION

(11) **EP 0 909 528 B1**
(45) Date of publication and mention of the grant of the patent: **24.09.2003**
(21) Application number: 97929332.1
(22) Date of filing: 03.07.1997
(51) Int. Cl.: H05K 7/14, H05K 7/18

(54) **CARD GUIDE FOR AN ELECTRONIC APPARATUS**
KARTENFÜHRUNGSLEISTE FÜR EINE ELEKTRONISCHE VORRICHTUNG
GUIDE-CARTE DESTINE A UN DISPOSITIF ELECTRONIQUE

(30) Priority: 03.07.1996 FI 962731
(43) Date of publication of application: 21.04.1999
(73) Proprietor: Nokia Corporation, 02150 Espoo (FI)
(72) Inventor: LEINONEN, Ismo, FIN-02140 Espoo (FI)
(74) Representative: Ruuskanen, Juha-Pekka
(86) International application number: FI9700435
(87) International publication number: WO98002024

(56) References cited:
- EP-A- 0 620 704
- GB-A- 1 324 574
- GB-A- 2 158 293
- US-A- 3 723 823
- US-A- 3 733 523
- US-A- 4 748 539
- US-A- 4 866 576

## Description

### Field of the invention

The invention relates generally to the mechanical structure of the subrack of an electronic apparatus. The electronic apparatus is typically a telecommunications device, and, more precisely, the invention relates to the card guide arrangement within such a device.

### Background of the invention

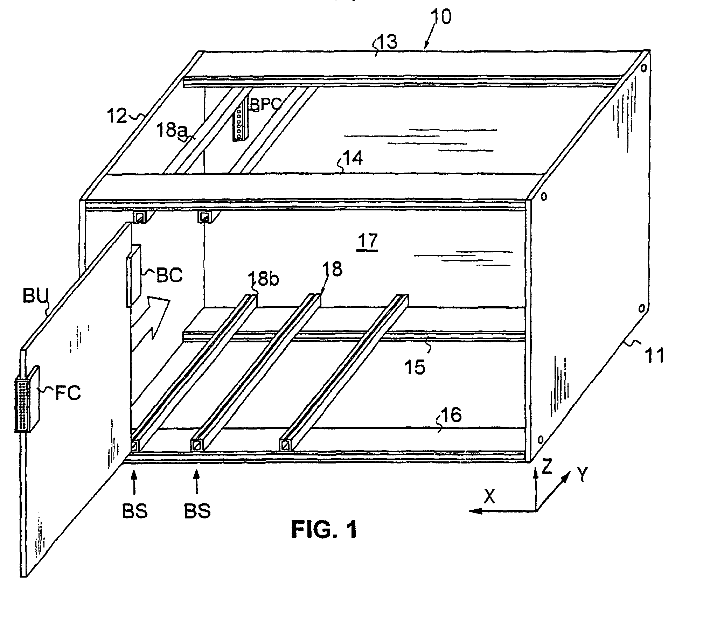

Figure 1 illustrates a known subrack structure of a telecommunications device on a general level. In this case, the subrack comprises a body 10 which, in this example, comprises vertical side panels 11 and 12, four essentially horizontal body beams 13 to 16, each of which is attached from one end to one comer of a side panel and from the other end to the corresponding end of the opposing side panel, and a back plane 17 on which have been formed the electric circuits (not shown) with which the card units (plug-in units) are connected to the telecommunications device of which the subrack is a part. In the back plane 17 there is a connector BPC at each card slot (only one connector is shown), by which the card unit BU is connected to the circuits located in the back plane.

An essential part of the subrack structure are the guide elements which guide the card units into their places in the subrack and which form the card slots into which the card units settle in the subrack. These elements are shown in the figure as rails 18, which are attached parallel to the side panels on the top surface of the bottommost subrack beams and on the bottom surface of the topmost subrack beams. The rail 18a, which is attached to the bottommost subrack beams and which always faces upwards, has a corresponding horizontal rail 18b in the same place in the topmost subrack beams which faces downwards, whereby the corresponding rails form the card slot BS, into which the single card unit BU is inserted and from which it can be detached by pulling. Generally, it can thereby be noted that the subrack contains several rail-like guide parts extending essentially parallel in the depth direction Y of the subrack and located in the width direction X of the subrack at intervals from one another. A single guide part has a pair which is located at the essentially corresponding place in the width direction of the subrack and in height direction Z of the subrack at a distance, whereby the guide part and its pair forms between themselves a card slot BS into which the electronic card of the device can be inserted and from which it can be detached (by pulling).

The card units BU to be inserted in the subrack (the figure shows one of these units) typically feature a front connector FC for connecting the card unit to external devices, and a back connector BC for connecting the card unit to the electric circuits formed in the back plane of the subrack. Each back connector BC is connected to the back plane connector BPC located in the back plane at the location of the card slot.

A telecommunications device of the type described above can be, for example, a subscriber multiplexer which contains, in a known manner, several parallel subscriber interface cards. Subscriber devices, such as telephones, are connected to the card units via the front connectors FC, the subscriber interface cards are connected via their back connectors BC, and the back plane connectors BPC to, for example, the internal bus of the multiplexer unit, the bus being formed on the back plane of the subrack.

In the following description, the card unit is referred to as a card, and the aforementioned guide elements are called card guides.

A card guide installed in the subrack is preferably made of plastic, because the manufacturing costs of such a guide are significantly less than those of a guide manufactured of metal, for example.

However, a general drawback of a plastic guide is that its thermal expansion is different from that of the (metal) subrack structure to which it is attached. The different thermal expansion rates of the subrack and the guide can thereby cause torsional stress in the cards and in that way damage the components installed on the cards. This is particularly a problem in the width direction of the subrack, because thermal expansion in this direction easily causes undesirable stress in the cards.

Therefore, the known card guides made of plastic are usually rails of the type shown in Figure 1, which are very narrow in the width direction of the subrack, whereby thermal expansion does not cause significant problems in this direction. Two of these rails are attached to the subrack for each card slot. The installation of card guides is a manual operation, which means that it demands quite a lot of time, thus raising the manufacturing costs of the subrack. The drawback is pronounced in the case of wide subracks; for example, in the case of a subrack that contains 17 card slots, there are 34 guide rails to be manually installed during the installation of the subrack.

### Summary of the invention

The purpose of the present invention is to create a card guide structure for the subrack in such a way that it is possible to eliminate the aforementioned problem with thermal expansion and which is, nevertheless, cheap to manufacture and simple to install during the manufacturing phase of the subrack. This objective is achieved by using a card guide arrangement according to the invention which features the characteristics described in the characterizing portion of the attached claim 1.

The idea of the invention is to manufacture from plastic material a guide part several card slots in width which is equipped in the sections between the anchoring points located on the subrack with parts which can compensate for the difference in the thermal expansion rate of the guide and the subrack.

According to one preferable embodiment of the invention, the card guide is, in the depth direction of the card, essentially narrower than the card unit, and the card slots are formed in the subrack by two guides which are successive in the depth direction of the subrack. This method results in a guide which is economically favorable and can also be used for cards of different sizes.

### Brief description of the drawings

The description of the invention and its preferred embodiments will now be made with reference to the examples shown in Figures 2 to 7 in the attached drawings, in which
- Figure 1: illustrates the known subrack structure of a telecommunications device,
- Figure 2: shows the subrack structure according to the invention,
- Figure 3: is a perspective view of a card guide according to the present invention,
- Figure 4: is a top view of a card guide according to the invention,
- Figure 5: is a side view of a card guide according to the invention,
- Figure 6: is a cross-sectional view of the card guide taken in the direction of the line C-C in Figure 4, and
- Figure 7: illustrates the attachment of the card guide to the panel located in the subrack.

### Detailed description of the invention

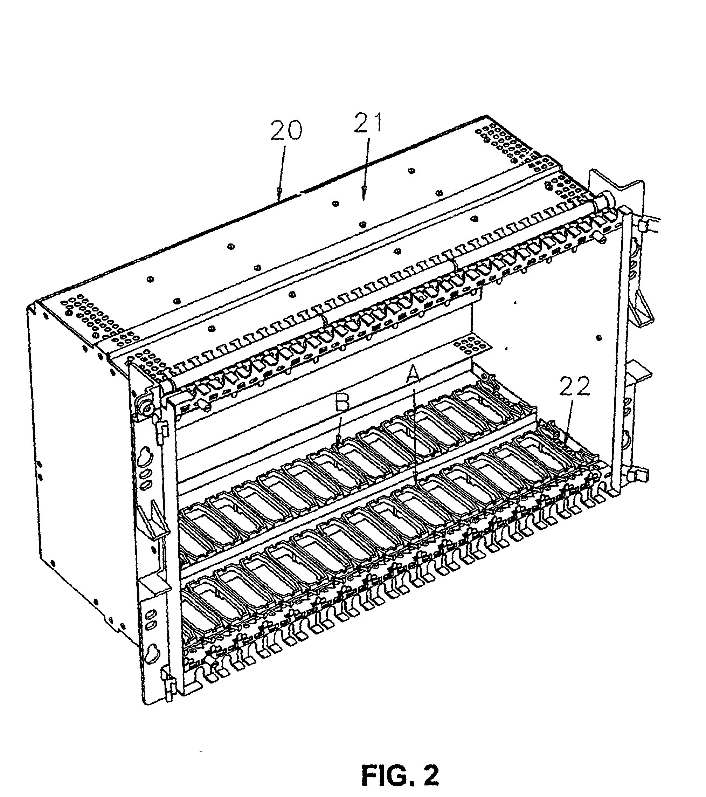

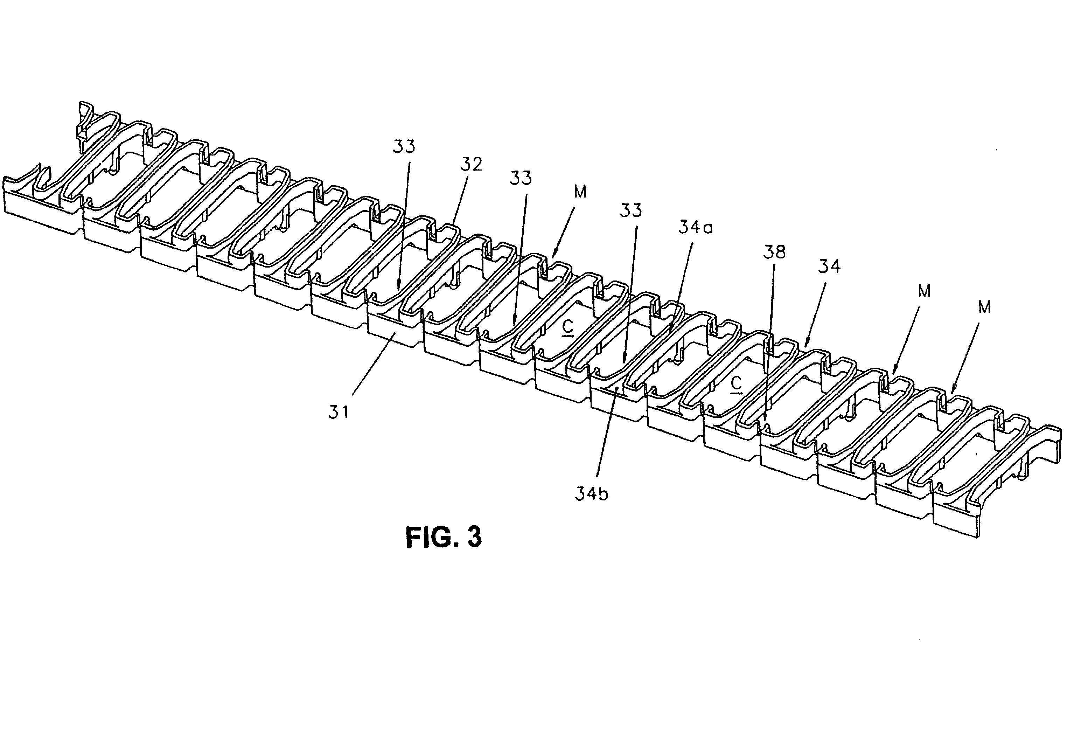

In the following a card guide according to the invention is described in more detail with reference to Figures 2 to 7, of which Figure 2 illustrates the entire subrack and Figures 3 to 7 illustrate the structure of a single card guide.

Figure 2 shows the subrack 20, in which the card guides indicated by the reference symbols A and B are used. The card guides shown in Figure 2 conform otherwise to the invention, but they lack the curved part essential for thermal expansion, which is illustrated in the later figures. The purpose of Figure 2 is, therefore, to illustrate the general structure of the card guide and the manner in which the card guides are installed in the subrack. According to the preferable embodiment of the invention, a single card guide is essentially narrower than the card itself in the depth direction of the subrack, so two card guides are installed in the subrack one after another in the depth direction of the subrack (also in the top part of the subrack), so that there is empty space between the guides. Compared to one wider card guide the tool costs of the guide can be decreased (because the mold cost for a small piece is correspondingly less). Furthermore, a narrow card guide can be used with several different card units by moving the rear card guide according to the length of the card so that the card can be supported in the depth direction near the back connector. (It is essential that the card guide supports the card near the back connector so that the card meets with the connector as precisely as possible, which also eliminates torsional stress.) A card guide narrow in the depth direction is also a preferable alternative to one card guide which is wide in the depth direction when considering thermal expansion in the direction in question.

In this example, the card guides form a total of 17 parallel card slots in the subrack. The horizontal panels of the subrack to which the card guides are attached are formed, in this case, from perforated plates 21 and 22 (only some of the holes have been shown). The holes improve the ventilation of the subrack and some of them function as the attachment holes for placing the card guides in the subrack. These attachment holes thereby operate, as far as thermal expansion is concerned, as anchoring points for the card guide.

Figure 3 is a perspective view of a single card guide A or B. In the width direction of the subrack, the card guide is an integral piece manufactured from plastic material several card slots in width and formed by the first and second side walls 31 and 32, which are essentially parallel to one another and separated at a certain distance from one another in the depth direction of the subrack, and by bridge parts 33, which connect the side walls and are narrow in the width direction of the subrack. The side walls and bridge parts form a ladder-like structure in which the side walls form a type of posts and the bridge parts form the horizontal steps of the ladder. Two bridge parts located one after another and the side wall parts between them thus outline an empty space C, which corresponds to the distance between the steps of the ladder.

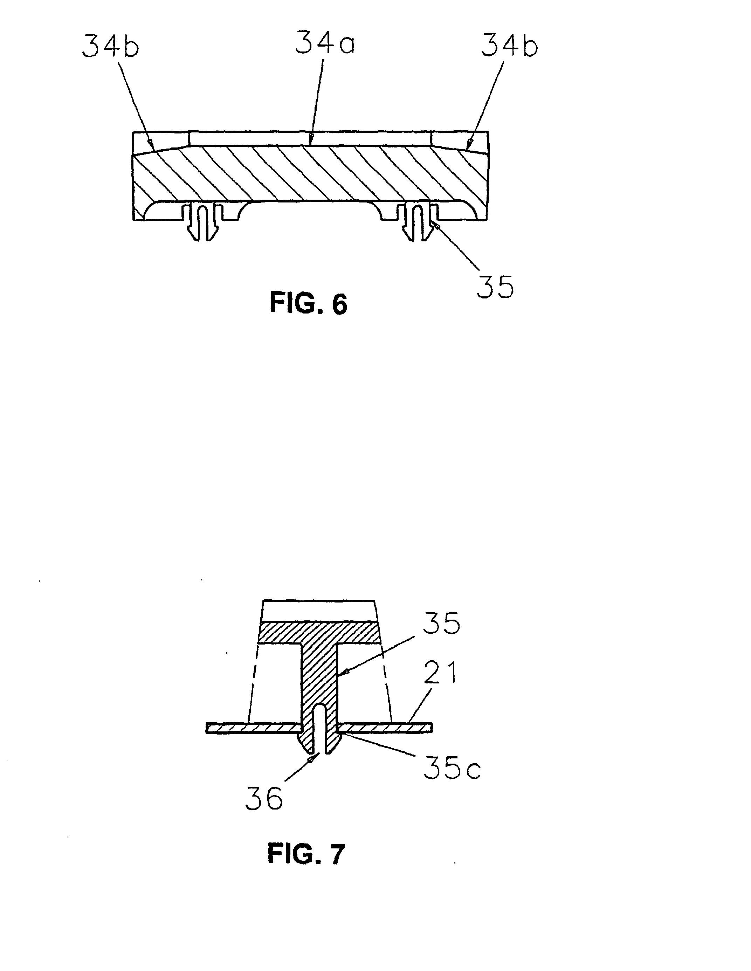

The surface of a single bridge part facing the interior of the subrack is equipped with a groove 34 within which the card edge settles. The groove comprises a part 34a, which remains essentially constant in width and which is also substantially horizontal, and of outwards widening mouth parts 34b, which are additionally tilted slightly downwards (cf., for example, Figure 6). These mouth parts make it easier for the card to slide into the groove.

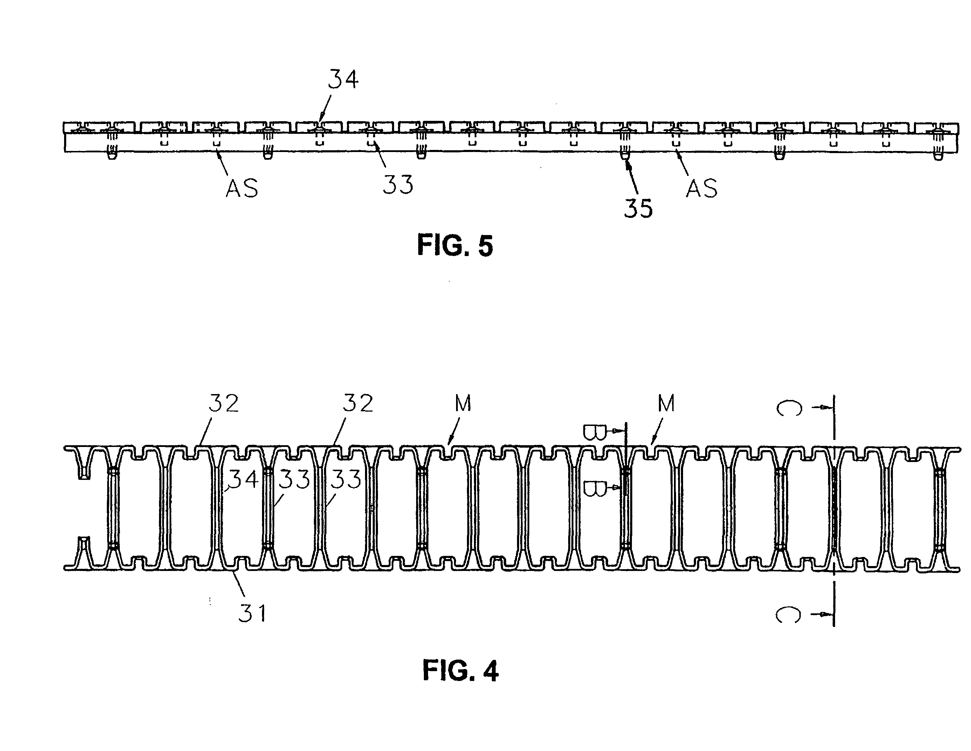

The card guides are attached to the subrack with vertical pegs 35 (cf., for example, Figure 5), which are formed at the bottom surfaces of some but not all of the bridge parts. In principle, the pegs could be located elsewhere on the bottom surface of the guide, but it is preferable to form the anchoring points (in the width direction) at the location of the cards. The bridge part equipped with pegs contains two pegs located at opposite ends of the constant width part 34a of the groove.

Because of the different thermal expansion rates of the subrack and the guide, the side walls form bends M between the bridge parts, at which point the wall deviates from the general plane of the wall. In this example, the bends are (seen from above) essentially U-shaped and extend inwards from the plane formed by the wall. The bends are especially visible in Figure 4, which shows the card guide as seen from the top. The walls are not thereby direct between two bridge parts, but they round an "extra" bend so that the length of the wall between the two points is longer than the shortest distance between the points in question. Therefore, these bends form something like thermal expansion bridges between the points in question, which allow the card guide to compress when the temperature rises. Because the thermal expansion factor of the plastic material of the card guide is higher than that of the subrack metal, the guide expands between the anchoring points by more than the subrack, which means that the card guide can compress at the thermal expansion bridges. In this manner the structure can accommodate the difference in the thermal expansion factors of the subrack and the guide.

Figure 7, a cross-sectional view in the direction of the line B-B in Figure 4 at the peg 35, illustrates the attachment of the card guide to the subrack. At the end of the peg is a groove 36, which makes the tip of the peg flexible. The open end of the tip is formed in a cone shape so that the largest diameter of the cone is larger than the diameter of the shaft of the peg, which is essentially equal to the diameter of the hole in plate 21 or 22. The peg is pushed into the hole in the plate 21 or 22, whereby the cone-shaped part flexes and snaps in place so that the essentially horizontal collar plane of the cone-shaped part settles against the panel surface on the side of the panel opposite to the guide. In this manner the guide locks in place in the subrack. As mentioned earlier, the locking points are preferably at the bridge parts, in which case the points at which the guide is "anchored" or "settled" in the subrack are formed at the locations of the bridge parts in question (i.e. at the location of the cards).

The "bottom surfaces" of the bridge parts (i.e. the surfaces located at the opposite side from the groove 34) are located "higher" than the surfaces of the walls (cf., for example, Figure 5), which are located against the plate 21 or 22, so that an air space, indicated in Figure 5 by reference symbol AS, is left between each bridge part and the plate. These air spaces improve the ventilation of the subrack (and thus decrease the thermal expansion).

The cards of the subrack can additionally be equipped with expansion cards attached to the actual telecommunications equipment via their mother cards. For this purpose, holes 38 are formed at the top of the curved parts. These holes support any expansion card attached to the actual card and form an "expansion card slot" for it. In this manner the curved parts can be used to increase the capacity of the subrack.

Although the invention was described above by referring to examples according to the attached drawings, it is clear that the invention is not limited to them, but can be altered within the idea of the invention described above and in the attached claims. For example, the width of the card guide varies in practice from 2 to 17 card slots.

## Claims

1. A card guide for a subrack of an electronic apparatus, which comprises
- an integral piece (A, B) manufactured of plastic material, the piece comprising
- first and second walls (31, 32) which extend essentially parallel to one another in the width direction of the card guide and are at a certain distance from one another in the depth direction of the card guide, and
- several bridge parts (33), narrow in the width direction of the card guide, which connect the walls and are located in the width direction of the card guide at a distance from one another, whereby two consecutive bridge parts, and the parts of the walls between them form an empty space (C) between them, a single bridge part being equipped with a groove (34), which operates as a rail-like guide part,
whereby the guide part together with another guide part, which together form a pair, form a card slot (BS) in which an electronic card (BU) of the apparatus can be inserted and from which it can be detached,
**characterized in that**
the walls (31, 32) of said piece form bends (M) between the bridge parts, the wall deviating from the general plane of the wall at said bends.

2. A card guide according to claim 1,**characterized in that** the dimension of said piece is in the depth direction at most one half of the width of the card in the direction in question.

3. A card guide according to claim 1, **characterized in that** it comprises vertical pegs (35) which are used to lock the piece in its place in the subrack.

4. A card guide according to claim 3, **characterized in that** the pegs (35) are located at said bridge parts in the width direction of the card guide.

5. A card guide according to claim 1, **characterized in that** the surfaces of the bridge parts (33) that face in the opposite direction from the groove (34) are on a different level from the surfaces of the walls that press against the subrack, whereby an air space (AS) is left between the bridge parts and the subrack when said piece is attached to the subrack.

6. A card guide according to claim 1, **characterized in that** the bends (M) are provided with holes (38) to support an extension card attached to the electronic card at its place in the subrack.

## Patentansprüche

1. Kartenführungsleiste für einen Baugruppenträger einer elektronischen Vorrichtung, mit
einem aus Kunststoff hergestellten, einstückigen Bauteil (A, B), das enthält:
erste und zweite Wände (31, 32), die sich im Wesentlichen parallel zueinander in der Breitenrichtung der Kartenführungsleiste erstrecken und einen gewissen Abstand voneinander in der Tiefenrichtung der Kartenführungsleiste einnehmen, und
mehrere in der Breitenrichtung der Kartenführungsleiste schmale Brückenteile (33), die die Wände verbinden und in der Breitenrichtung der Kartenführungsleiste mit einem Abstand voneinander angeordnet sind, wobei zwei aufeinanderfolgende Brückenteile und die Bestandteile der Wände zwischen ihnen einen Hohlraum (C) dazwischen ausbilden, wobei ein einzelnes Brückenteil mit einer Nut (34) ausgestattet ist, die als schienenähnliches Führungsteil dient,
wobei das Führungsteil zusammen mit einem anderen Führungsteil, die zusammen ein Paar ausbilden, einen Kartenschlitz (BS) ausbilden, in den eine elektronische Karte (BU) der Vorrichtung eingeführt und aus dem sie entnommen werden kann,
**dadurch gekennzeichnet, dass**
die Wände (31, 32) des Bauteils Ausbuchtungen (M) zwischen den Brückenteilen ausbilden, wobei die Wand an den Ausbuchtungen von der Hauptebene der Wand abweicht.

2. Kartenführungsleiste gemäß Anspruch 1,
**dadurch gekennzeichnet, dass** die Abmessung des Bauteils in der Tiefenrichtung höchstens die Hälfte der Breite der Karte in der betreffenden Richtung ist.

3. Kartenführungsleiste gemäß Anspruch 1,
**dadurch gekennzeichnet, dass** sie vertikale Zapfen (35) hat, die zum Verriegeln des Bauteils an seinem Platz in dem Baugruppenträger dienen.

4. Kartenführungsleiste gemäß Anspruch 3,
**dadurch gekennzeichnet, dass** die Zapfen (35) an den Brückenteilen in der Breitenrichtung der Kartenführungsleiste angeordnet sind.

5. Kartenführungsleiste gemäß Anspruch 1,
**dadurch gekennzeichnet, dass** die Oberflächen der Brückenteile (33), die in die entgegengesetzte Richtung von der Nut (34) zeigen, von den Oberflächen der Wände, die gegen den Baugruppenträger drücken, auf unterschiedlichem Niveau sind, wodurch ein Luftraum (AS) zwischen den Brückenteilen und dem Baugruppenträger verbleibt, wenn das Bauteil an dem Baugruppenträger angebracht ist.

6. Kartenführungsleiste gemäß Anspruch 1,
**dadurch gekennzeichnet, dass** die Ausbuchtungen (M) mit Löchern (38) ausgestattet sind, um eine Verlängerungskarte, die an der elektronischen Karte befestigt ist, an ihrem Platz in dem Baugruppenträger zu stützen.

## Revendications

1. Guide-carte destiné à un bac d'un dispositif électronique, qui comprend :
- un élément intégral (A, B) fabriqué en matière plastique, l'élément comprenant :
- des première et deuxième parois (31, 32) qui s'étendent essentiellement parallèlement l'une à l'autre dans le sens de la largeur du guide-carte et qui sont à une certaine distance l'une de l'autre dans le sens de la profondeur du guide-carte, et
- plusieurs parties de pont (33), étroites dans le sens de la largeur du guide-carte, qui relient les parois et qui sont situées dans le sens de la largeur du guide-carte à une certaine distance les unes des autres, moyennant quoi deux parties de pont consécutives, et les parties des parois entre elles, forment un espace vide (C) entre elles, une seule partie de pont étant pourvue d'une rainure (34), qui agit en tant que partie de guidage semblable à un rail, moyennant quoi la partie de guidage avec une autre partie de guidage, qui forment ensemble une paire, forment un emplacement de carte (BS) dans lequel une carte électronique (BU) du dispositif peut être insérée et duquel elle peut être retirée,
**caractérisé en ce que**
les parois (31, 32) dudit élément forment des coudes (M) entre les parties de pont, la paroi s'écartant du plan général de la paroi au niveau desdits coudes.

2. Guide-carte selon la revendication 1, **caractérisé en ce que** la dimension dudit élément correspond, dans le sens de la profondeur, au plus à la moitié de la largeur de la carte dans le sens en question.

3. Guide-carte selon la revendication 1, **caractérisé en ce qu'**il comprend des taquets verticaux (35) qui sont utilisés pour bloquer l'élément à sa place dans le bac.

4. Guide-carte selon la revendication 3, **caractérisé en ce que** les taquets (35) sont situés au niveau desdites parties de pont dans le sens de la largeur du guide-carte.

5. Guide-carte selon la revendication 1, **caractérisé en ce que** les surfaces des parties de pont (33) qui sont orientées dans la direction opposée à la rainure (34) sont sur un niveau différent de celui des surfaces des parois qui s'appuient sur le bac, moyennant quoi un espace d'air (AS) est laissé entre les parties de pont et le bac lorsque ledit élément est fixé au bac.

6. Guide-carte selon la revendication 1, **caractérisé en ce que** les coudes (M) sont pourvus de trous (38) afin de supporter une carte d'extension fixée à la carte électronique à sa place dans le bac.
